# EUROPEAN PATENT APPLICATION

(11) **EP 4 303 605 A1**
(43) Date of publication of application: **10.01.2024**
(21) Application number: 22183613.3
(22) Date of filing: 07.07.2022
(51) Int. Cl.: G01R 33/48, G01R 33/56, G01R 33/561, G01R 33/44, G01R 33/50

(54) **MULTIPLE MAGNETIC RESONANCE IMAGE ACQUISITION WITH MULTIPLE CONTRASTS DURING MULTI-ECHO GRADIENT ECHO MAGNETIC RESONANCE IMAGING**

(71) Applicant: Koninklijke Philips N.V., 5656 AG Eindhoven (NL)
(72) Inventor: YONEYAMA, Masami, Eindhoven (NL); SHUO, Zhang, Eindhoven (NL); STEHNING, Christian, 5656 AG Eindhoven (NL); KOUWENHOVEN, Marc, 5656 AG Eindhoven (NL); VAN CAUTEREN, Marc, Eindhoven (NL); RAJENDRAN, Karthick, Eindhoven (NL); KATEMANN, Christoph, Eindhoven (NL)
(74) Representative: Philips Intellectual Property & Standards

(57) **Abstract**

Disclosed herein is a medical system (100) comprising a magnetic resonance imaging system (102). The execution of the machine executable instructions (140) causes a computational system (132) to: control (200) the magnetic resonance imaging system with multi-echo gradient echo pulse sequence commands to acquire the k-space data (144), form (202) a first k-space data group (146) by aggregating a first selected k-space data portion, form (204) a second k-space data group (148) by aggregating a second selected k-space data portion, form (206) at least one additional k-space data group (150) by aggregating an additional selected k-space data portion; reconstruct (208) a first Dixon water image (152) from the first k-space data group, reconstruct (210) a second Dixon water image (154) from the second k-space data group, and reconstruct (212) an additional magnetic resonance image (156) from each of the at least one additional k-space data group.

## Description

### FIELD OF THE INVENTION

The invention relates to magnetic resonance imaging, in particular to magnetic resonance angiography.

### BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field. Various quantities or properties of the subject can be measured spatially using MRI. For example, imaging of the blood vessels and blood can be performed using magnetic resonance imaging.

The conference proceeding Yoneyama et. al., "REACT-MD: simultaneous non-contrast-enhanced subclavian MRA and fat suppressed direct thrombus imaging with a large field-of-view," Proc. Intl. Soc. Mag. Reson. Med. 28 (2020) pp. 1320 discloses the direct visualization of the plaques and vessel wall lesion in addition to luminal changes. It further discloses a REACT (Relaxation-Enhanced Angiography without ContrasT) technique that has been configured with Multiple Delays (REACT-MD) that simultaneously provides non-contrast-enhanced MR angiogram and MPRAGE (magnetization prepared rapid gradient echo) type images with uniform background tissue suppression over a large field of view. Initial results in patient showed great promise in the detection of luminal changes and plaques for the assessment of systemic atherosclerosis in one single scan.

### SUMMARY OF THE INVENTION

The invention provides for a medical system, a computer program, and a method in the independent claims. Embodiments are given in the dependent claims.

There are difficulties with magnetic resonance when trying to acquire multiple images with multiple contrasts. One difficulty is that it takes time to acquire the k-space data for each imaging modality. If the subject moves the images need to be registered. Non-rigid motions can be problematic to register to one another. Particularly when there three or more images. Embodiments may provide for automatic registration between multiple magnetic resonance images. This may be achieved by combining multiple imaging modalities into a single pulse sequence. Since the k-space data for all modalities is acquired using the same pulse sequence the effects of patient motion on the registration between the two modalities is greatly reduced.

In one aspect the invention provides for a medical system that comprises a magnetic resonance imaging system that is configured for acquiring k-space data from a subject. The k-space data may be acquired from a field of view. The medical system further comprises a memory that stores machine-executable instructions and pulse sequence commands. The pulse sequence commands are configured to control the magnetic resonance imaging system to acquire the k-space data during multiple acquisition shots according to a multi-echo gradient echo magnetic resonance imaging protocol. For each of the multiple acquisition shots, the pulse sequence commands are further configured to control the magnetic resonance imaging system to perform multiple k-space data readouts to acquire three or more k-space data portions. The pulse sequence commands are further configured such that each of the three or more k-space data portions has a readout delay. This may be considered as saying that the readout occurs after a readout delay. For each of these three or more k-space data portions the readout delay may be different. Execution of the machine-executable instructions causes the computational system to control the magnetic resonance imaging system with the pulse sequence commands to acquire the k-space data.

Execution of the machine-executable instructions further causes the computational system to form a first k-space data group by aggregating a first selected k-space data portion selected from the three or more k-space data portions from each of the multiple acquisition shots. Execution of the machine-executable instructions further causes the computational system to form a second k-space data group by aggregating a second selected k-space data portion selected from the three or more k-space data portions. The first k-space data group has a first readout delay and the second k-space data group has a second readout delay. The terms first readout delay and the second readout delay are used to identify particular readout delays that these two k-space data portions have. The second readout delay is greater than the first readout delay. The readout delays select the conversion time at which the particular acquisition of the k-space occurs.

Execution of the machine-executable instructions further causes the computational system to form at least one additional k-space data group by aggregating an additional selected k-space data portion each selected from the three or more k-space data portions. Execution of the machine-executable instructions further causes the computational system to reconstruct a first Dixon water image from the first k-space data group to provide a bright-blood non-contrast enhanced magnetic resonance imaging angiogram. Execution of the machine-executable instructions further causes the computational system to reconstruct a second Dixon water image from the second k-space data group to provide a black-blood magnetic resonance vessel wall image. Execution of the machine-executable instructions further causes the computational system to reconstruct an additional magnetic resonance image from each of the at least one additional k-space data group. This embodiment may be beneficial because the first Dixon water image, the second Dixon water image, and the additional magnetic resonance image or images were acquired together using this multiple k-space data readout method. Because of this all of these images are automatically aligned. This may also result in a significant time saving in respect to acquiring these images separately.

In another embodiment the multi-echo gradient echo magnetic resonance imaging protocol is a Dixon magnetic resonance imaging protocol. In some further embodiments the Dixon magnetic resonance imaging protocol is a multi-point Dixon magnetic resonance imaging protocol.

In another embodiment the multi-point Dixon magnetic resonance imaging protocol is a two-dimensional or three-dimensional turbo field-echo Dixon magnetic resonance imaging protocol.

In another embodiment the multiple k-space data readouts are performed using inversion recovery pulses. In an embodiment the inversion recovery pulses for the acquisition shots are non-selective inversion recovery pulses.

In another embodiment the at least one of the additional magnetic resonance image, that is reconstructed from the at least one additional k-space data group, comprises at least one Dixon image. The at least one Dixon image comprises any one of the following: a water image, a fat image, a fat fraction map, a B0 map, and combinations thereof.

In some instances, it may be particularly beneficial to acquire the k-space data to reconstruct the at least one Dixon image at a third or further readout delay that is longer than the second readout delay. This is because the fat image and the fat fraction map may be more accurate because the longer inversion time enables both the fat and water-containing tissues to have a more complete inversion recovery. In theory a fat fraction map or other Dixon images for use in conventional Dixon analysis could be reconstructed from the first k-space data group or the second k-space data group, however this may not be very advantageous because, as it was mentioned, there may be inaccuracies in particularly the fat fraction map.

In another embodiment the at least one Dixon image comprises the B0 map. Execution of the machine-executable instructions further causes the computational system to reconstruct a magnitude image and a phase image from each of the first k-space data group, the second k-space data group, and each of the at least one additional k-space data group or groups. Execution of the machine-executable instructions further causes the computational system to calculate a quantitative susceptibility map from the B0 map and from magnitude and phase image from each of: the first k-space data group, the second k-space data group, and each of the at least one additional k-space data group.

In another embodiment execution of the machine-executable instructions further causes the computational system to reconstruct at least one quantitative magnetic resonance image from the k-space data. In this embodiment the k-space data as a whole is used to calculate the at least one quantitative magnetic resonance image. Examples of this previously discussed are a calculation of the T2-star map and the quantitative susceptibility map.

In another embodiment the at least one quantitative magnetic resonance image comprises a T2-star map. Execution of the machine-executable instructions further causes the computational system to reconstruct a magnitude image from the first k-space data group, the second k-space data group, and each of the at least one k-space data group. Execution of the machine-executable instructions further causes the computational system to calculate the T2-star map by performing a fitting to the magnitude image and the readout delay of each of the three or more k-space data portions.

In another embodiment execution of the machine-executable instructions further causes the computational system to form a k-space data grouping for each of the three or more k-space data portions by aggregating the k-space data corresponding to a first echo of each of the three or more k-space data portions or corresponding to a Dixon water image of each of the three or more k-space data portions. Execution of the machine-executable instructions further causes the computational system to calculate a T1 map from the k-space data grouping.

In another embodiment the second readout delay is configured such that a longitudinal magnetization of the blood has a magnitude below a predetermined blood magnetization threshold. This embodiment may be beneficial because it enables the blood to be cancelled out in the magnetic resonance image. The second readout delay may be optimally chosen such that the signal from the blood is canceled out, however, as long as it is below or reasonably close to zero then this will still function well.

In another embodiment the second readout delay is configured to occur at a zero-crossing of a longitudinal magnetization of blood.

In another embodiment the first readout delay is configured such that the longitudinal magnetization of blood is below a predetermined tissue magnetization threshold.

In another embodiment the first readout delay is configured to occur at a zero-crossing of a longitudinal magnetization of any one of the following: muscle tissue, nerve tissue, internal organ tissue, and an average of one or more of the preceding.

In another embodiment execution of the machine-executable instructions further causes the computational system to form a composite magnetic resonance angiogram and vessel image by overlaying the first Dixon water image and the second Dixon water image. Execution of the machine-executable instructions further causes the computational system to overlay at least one additional magnetic resonance image on the composite magnetic resonance angiogram and the vessel image. This embodiment may be beneficial because of the way that the k-space data was acquired the subsequent images are all automatically aligned and do not need to be motion compensated.

In another embodiment the pulse sequence commands are configured to acquire the k-space data during multiple acquisition shots according to a rotating non-Cartesian sampling pattern. Normally there is a particular sampling pattern and in between acquisition shots the sampling pattern is rotated by the so-called golden angle. However, rotating by the golden angle is not necessary although it is normally performed this way.

In another embodiment the rotating non-Cartesian sampling pattern is either a spiral sampling pattern or a radial stack-of-stars sampling pattern.

In another embodiment the pulse sequence commands are configured to acquire the k-space data during the multiple acquisition shots continuously. Execution of the machine-executable instructions further causes the computational system to form the first k-space data portion, the second k-space data portion and each of the at least one additional k-space data portions retrospectively. That is to say the k-space data is acquired continuously and then the readout delay for the different k-space data portions is then determined after the acquisition is finished. This may have the advantage of enabling a more accurate determination of the first readout delay, the second readout delay and/or any additional readout delays used to reconstruct the additional magnetic resonance image or images.

Execution of the machine-executable instructions further causes the computational system to adjust a location of a first sliding window to group the k-space data into the first k-space data portion.

In another embodiment execution of the machine-executable instructions further causes the computational system to adjust the location of a second sliding window to group the k-space data into the second k-space data portion.

In another embodiment execution of the machine-executable instructions further causes the computational system to adjust a location of an additional sliding window for each of the at least one additional k-space data portion to group the k-space data into each of the at least one additional k-space data portion or portions. These embodiments with the adjusting the location of the various sliding windows may be beneficial because it may provide for a better determination of the readout delay which may enable better cancellation of the magnetization of various tissue types.

In another embodiment execution of the machine-executable instructions further causes the computational system to iteratively adjust the first sliding window location, the second sliding window location, and/or each additional sliding window location to optimize an image quality of the first Dixon water image, the second Dixon water image, and/or additional magnetic resonance images. This for example may be done by reconstructing these images and then applying an image metric such as the sharpness or contrast and then making iterative variations of the various sliding window locations to optimize that particular image. In some instances, the anatomy, which is being imaged in the particular image, may be known and then a model of this anatomy may be used during the iterative process. For example, anatomical structures detected in the image may be used to or reduced to optimize cancelation of magnetization due to water or blood.

In another embodiment the pulse sequence commands are further configured to iteratively perform magnetization preparation pulses for each of the multiple acquisition shots. The magnetization preparation pulses are preferably configured to suppress magnetic resonance imaging signals from muscle tissue, nerve tissue, blood, and/or internal organ tissue and wherein the pulse sequence commands are further configured to perform inversion recovery pulse with the magnetization preparation pulse. The delay from when the magnetization preparation pulse is applied may be considered to be the readout delay for the various k-space data groups.

In another embodiment the magnetization preparation pulses are T2 preparation pulses. That is to say that the k-space data which was acquired has a T2 weighting.

In another aspect the invention provides for a method of operating a medical system that comprises a magnetic resonance imaging system configured for acquiring k-space data from a subject. The method comprises controlling the magnetic resonance imaging system with the pulse sequence commands to acquire the k-space data. The pulse sequence commands are configured to control the magnetic resonance imaging system to acquire the k-space data during multiple acquisition shots according to a multi-echo gradient echo magnetic resonance imaging protocol. For each of the multiple acquisition shots the pulse sequence commands are further configured to control the magnetic resonance imaging system to perform multiple k-space data readouts to acquire three or more k-space portions.

The pulse sequence commands are further configured such that each of the three or more data portions has a readout delay when these various readouts occur. The method further comprises forming a first k-space data group by aggregating a first selected k-space data portion selected from the three or more k-space data portions from each of the multiple acquisition shots. The method further comprises forming a second k-space data group by aggregating a second selected k-space data portion selected from the three or more k-space data portions. The first k-space data group has a first readout delay. The second k-space data group has a second readout delay. The second readout delay is greater than the first readout delay.

The method further comprises forming at least one additional k-space data group by aggregating an additional selected k-space data portion which are each selected from the three or more k-space data portions. The method further comprises reconstructing a first Dixon water image from the first k-space data group to provide a bright-blood non-contrast enhanced magnetic resonance imaging angiogram. The method further comprises reconstructing a second Dixon water image from the second k-space data group to provide a black-blood magnetic resonance vessel wall image. The method further comprises reconstructing an additional magnetic resonance image from each of the at least one additional k-space data group.

In another aspect the invention provides for a computer program that comprises machine-executable instructions and also possibly the pulse sequence commands. The machine-executable instructions are for execution by a computational system that controls a medical system. The medical system comprises a magnetic resonance imaging configured for acquiring k-space data from a subject. The execution of the machine-executable instructions causes the computational system to control the magnetic resonance imaging system with the pulse sequence commands to acquire the k-space data. The pulse sequence commands are configured to control the magnetic resonance imaging system to acquire the k-space data during multiple acquisition shots according to a multi-echo gradient echo magnetic resonance imaging protocol. For each of the multiple acquisition shots the pulse sequence commands are further configured to control the magnetic resonance imaging system to perform multiple k-space data readouts to acquire three or more k-space data portions.

The pulse sequence commands are configured such that each of the three or more k-space data portions has a readout delay. The execution of the machine-executable instructions further causes the computational system to form a first k-space data group by aggregating a first selected k-space data portion selected from the three or more k-space data portions from each of the multiple acquisition shots. Execution of the machine-executable instructions further causes the computational system to form a second k-space data group by aggregating a second selected k-space data portion selected from the three or more k-space data portions. The first k-space data group has a first readout delay. The second k-space data group has a second readout delay. The second readout delay is greater than the first readout delay.

Execution of the machine-executable instructions further causes the computational system to form at least one additional k-space data group by aggregating an additional selected k-space data portion for each of the three or more k-space data portions. Execution of the machine-executable instructions further causes the computational system to reconstruct a first Dixon water image from the first k-space data group to provide a bright-blood non-contrast enhanced magnetic resonance imaging angiogram. Execution of the machine-executable instructions further causes the computational system to reconstruct a second Dixon water image from the second k-space data group to provide a black-blood magnetic resonance vessel wall image. Execution of the machine-executable instructions further causes the computational system to reconstruct an additional magnetic resonance image from each of the at least one additional k-space data group.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data.

A Magnetic Resonance Imaging (MRI) image or MR image is defined herein as being the reconstructed two- or three-dimensional visualization of anatomic data contained within the magnetic resonance imaging data. This visualization can be performed using a computer.

A contrast, in the nominative form, as used herein refers to the particular acquisition or reconstruction parameters used for a magnetic resonance image. For example, a reference to multiple or various contrast types means that a varies of acquisition parameters or reconstruction parameters were used for the acquisition of the k-space data or for the reconstruction of the k-space data. The variation of these parameters may have an impact on the image contrast and/or the anatomical structures displayed in the magnetic resonance image.

### BRIEF DESCRIPTION OF THE DRAWINGS

In the following preferred embodiments of the invention will be described, by way of example only, and with reference to the drawings in which:
Fig. 1 illustrates an example of a medical system;
Fig. 2 shows a flow chart which illustrates a method of using the medical system of Fig. 1;
Fig. 3 shows a schematic representation of a pulse sequence and signal evolution during the pulse sequence;
Fig. 4 illustrates a signal readout with a radial stack-of-stars k-space sampling pattern as well as examples of an image that uses cartesian and non-cartesian sampling;
Fig. 5 illustrates several images acquired using the medical system of Fig. 1;
Fig. 6 illustrates additional images acquired using the medical system of Fig. 1; and
Fig. 7 illustrates sliding windows used to group continuously acquired k-space data .

### DESCRIPTION OF EMBODIMENTS

Like numbered elements in these figures are either equivalent elements or perform the same function. Elements which have been discussed previously will not necessarily be discussed in later figures if the function is equivalent.

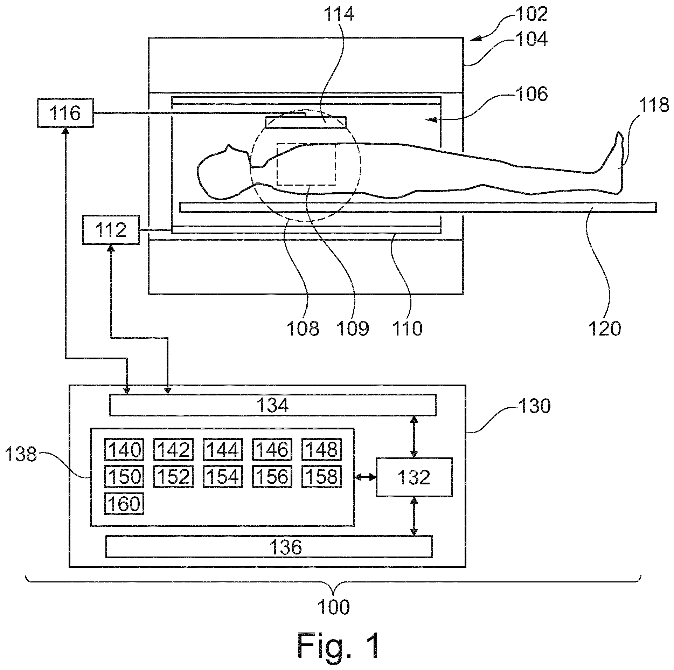

Fig. 1 illustrates an example of a medical system 100 that comprises a magnetic resonance imaging system 102. The magnetic resonance imaging system 102 comprises a magnet 104. The magnet 104 is a superconducting cylindrical type magnet with a bore 106 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 106 of the cylindrical magnet 104 there is an imaging zone 108 where the magnetic field is strong and uniform enough to perform magnetic resonance imaging. A field of view 109 is shown within the imaging zone 108. The magnetic resonance data that is acquired typically acquried for the field of view 109. A subject 118 is shown as being supported by a subject support 120 such that at least a portion of the subject 118 is within the imaging zone 108 and the predetermined region of interest 109.

Within the bore 106 of the magnet there is also a set of magnetic field gradient coils 110 which is used for acquisition of preliminary magnetic resonance data to spatially encode magnetic spins within the imaging zone 108 of the magnet 104. The magnetic field gradient coils 110 connected to a magnetic field gradient coil power supply 112. The magnetic field gradient coils 110 are intended to be representative. Typically, magnetic field gradient coils 110 contain three separate sets of coils for spatially encoding in three orthogonal spatial directions. A magnetic field gradient power supply supplies current to the magnetic field gradient coils. The current supplied to the magnetic field gradient coils 110 is controlled as a function of time and may be ramped or pulsed.

Adjacent to the imaging zone 108 is a radio-frequency coil 114 for manipulating the orientations of magnetic spins within the imaging zone 108 and for receiving radio transmissions from spins also within the imaging zone 108. The radio frequency antenna may contain multiple coil elements. The radio frequency antenna may also be referred to as a channel or antenna. The radio-frequency coil 114 is connected to a radio frequency transceiver 116. The radio-frequency coil 114 and radio frequency transceiver 116 may be replaced by separate transmit and receive coils and a separate transmitter and receiver. It is understood that the radio-frequency coil 114 and the radio frequency transceiver 116 are representative. The radio-frequency coil 114 is intended to also represent a dedicated transmit antenna and a dedicated receive antenna. Likewise, the transceiver 116 may also represent a separate transmitter and receivers. The radio-frequency coil 114 may also have multiple receive/transmit elements and the radio frequency transceiver 116 may have multiple receive/transmit channels. For example, if a parallel imaging technique such as SENSE is performed, the radio-frequency could 114 will have multiple coil elements.

The transceiver 116 and the gradient controller 112 are shown as being connected to the hardware interface 106 of the computer system 102.

The medical system 100 is further shown as comprising a computer 130. The computer 130 is intended to represent one or more computing or computational devices located at one or more locations. The computer 130 is shown as containing a computational system 132. The computational system 132 is intended to represent one or more computational systems that could for example be one or more processing cores located at one or more locations. Various combinations of computational systems 132 and/or computers 130 could be connected and work together cooperatively using a network. The computational system 132 is shown as being in communication with a hardware interface 134, a user interface 136, and a memory 138. The hardware interface 134 is an interface which enables the computational system 132 to communicate with and/or control other components of the medical system 100 such as the magnetic resonance imaging system 102. The user interface 136 is a user interface that enables an operator of the medical system 100 to control and operate the medical system 100. The memory 138 is intended to represent various types of memory which may be in communication with the computational system 132.

The memory 138 is shown as containing machine-executable instructions 140. The machine-executable instructions 140 enable the computational system 132 to perform basic tasks such as image processing, control of the magnetic resonance imaging system 102 and various computational and data manipulation tasks. The memory 138 is further shown as containing pulse sequence commands 142. The pulse sequence commands are configured to control the magnetic resonance imaging system to acquire the k-space data during multiple acquisition shots according to a multi-echo gradient echo magnetic resonance imaging protocol. The memory 138 is further shown as containing k-space data 144 that has been acquired by controlling the magnetic resonance imaging system 102 with the pulse sequence commands 142. The memory 138 is further shown as containing a first k-space data group, a second k-space data group 148 and an at least one additional k-space data group 150 that have been formed from the k-space data 144. The memory 138 is further shown as containing a first Dixon water image 152 that has been reconstructed from the first k-space data group 146. The memory 138 is further shown as containing a second Dixon water image 154 that has been reconstructed from the second k-space data group 148. The memory 138 is further shown as containing an additional magnetic resonance image 156 that has been reconstructed from the additional k-space data group 150. The memory 138 is further shown as containing an optional composite image 158 that has been formed by combining the image data from the first Dixon water image 152, the second Dixon water image 154, and the additional magnetic resonance image 156. The memory 138 is further shown as containing an optional quantitative magnetic resonance image 160 that has been reconstructed from the k-space data 144 as a whole.

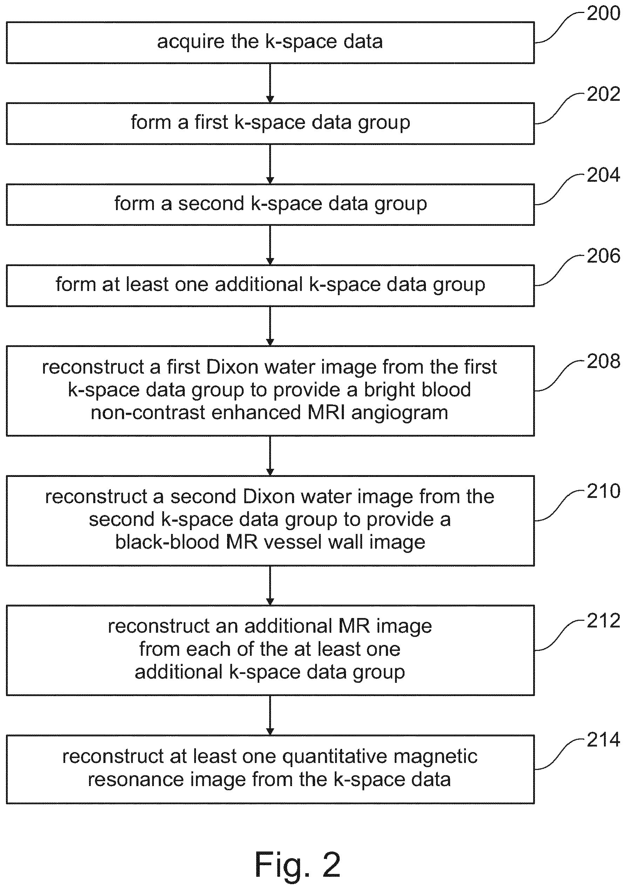

Fig. 2 shows a flowchart which illustrates a method of operating the medical system 100 of Fig. 1. First, in step 200, the magnetic resonance imaging system 102 is controlled with the pulse sequence commands 142 to acquire the k-space data 144. The pulse sequence commands are configured such that for each of the multiple acquisition shots the pulse sequence commands are further configured to control the magnetic resonance imaging system to perform multiple k-space readouts to acquire three or more k-space portions. The pulse sequence commands are further configured such that each of the three or more k-space portions has a readout delay.

Next, in step 202, the first k-space group 146 is formed by aggregating a first selected k-space portion selected from the three or more k-space portions from each of the multiple acquisition shots. Then, in step 204, the second k-space group 148 is formed by aggregating a second selected k-space portion selected from the three or more k-space data portions. The first k-space data group has a first readout delay, the second k-space group has a second readout delay. The second readout delay is greater than the first readout delay.

Next, in step 206, at least one additional k-space data group 150 is formed by aggregating an additional selected k-space data portion for each selected from the three or more k-space data portions. Next, in step 208, a first Dixon water image 152 is reconstructed from the first k-space data group to provide a bright-blood non-contrast enhanced magnetic resonance imaging angiogram. Next, in step 210, a second Dixon water image 154 is reconstructed from the second k-space data group to provide a black-blood magnetic resonance vessel wall image. Finally, in step 212, an additional magnetic resonance image 156 is reconstructed from each of the at least one additional k-space data group that was formed.

After step 212 is performed optional step 214 may be performed. In step 214 at least one quantitative magnetic resonance image 160 is reconstructed from the k-space data 144. The first Dixon water image 152, the second Dixon water image 154 and any additional magnetic resonance images 156 were reconstructed from individual k-space data groups 146, 148, 150. The quantitative magnetic resonance image 160 may be reconstructed from the k-space data 144 as a whole. The production of the quantitative magnetic resonance image 160 in this way may be particularly beneficial because normally the quantitative magnetic resonance image 160 is reconstructed from a variety of images that are acquired separately.

Clinical imaging procedure for vascular evaluation and tissue characterization are separated MR exams. Both scenarios require multiple imaging sequences with different image contrasts, typically referred as multi-parametric MRI (mpMRI). These include, for example, bright-blood, dark-blood, T1-weighted, and T2^{∗}-weighted contrasts. This results in 1) long exam times, 2) image datasets misalignment due to possible motion between the scans that need to be corrected in post-processing. Furthermore, existing quantitative multi-parametric measurements rely on dedicated modeling and additional processing, and do not provide angiographic information, in which case a complete diagnosis is compromised.

Examples may apply magnetization-prepared multi-delay (at least two), multi-echo (at least three, typically six) data acquisitions and chemical-shift-based water-fat separation with either Cartesian or non-Cartesian k-space trajectory, for simultaneous multi-contrast imaging (e.g., T1-weighting, T2^{∗}- or susceptibility-weighting, bright- / black- / gray-blood-weighting) and supplementary multi-parametric quantitative mapping (e.g., fat fraction map, T2^{∗} map, T1 map, T2 map, etc.) without the need for any biophysical modeling or dictionary matching.

The overall scan time may be much reduced (2- to 4-fold) comparing to acquisition of multiple contrasts and/or parametric maps using separate sequences. Further, since all contrasts are reconstructed from the same raw data, there is no risk of misalignment. Even for examinations with ECG synchronization, all data are consistently acquired in the same cardiac phase. Direction application includes detection and assessment of vascular lesions, vessel wall lesions and tumorous lesions.

Examples may provide for an MRI technique for simultaneous vascular imaging and multi-parametric relaxometry for quantitative tissue characterization including T2^{∗}, fat fraction, T1, etc.

Examples may provide for one or more of the following functionalities or features:
- Relaxation-Enhanced Angiography without ContrasT (REACT), for non-contrast MR angiography (MRA)
- Relaxation-Enhanced Angiography without ContrasT with multi-delay (REACT-MD), for simultaneous non-contrast MRA and dark-blood vessel wall imaging (VWI)
- mDixon Quant for fat fraction (FF) and iron quantification
- Pseudo-golden-angle radial stack-of-stars imaging

REACT-MD is based on magnetization-prepared multi-delay (typically two) acquisitions, while mDixon Quant is based on multi-echo (typically six) fast field-echo (FFE) technique.

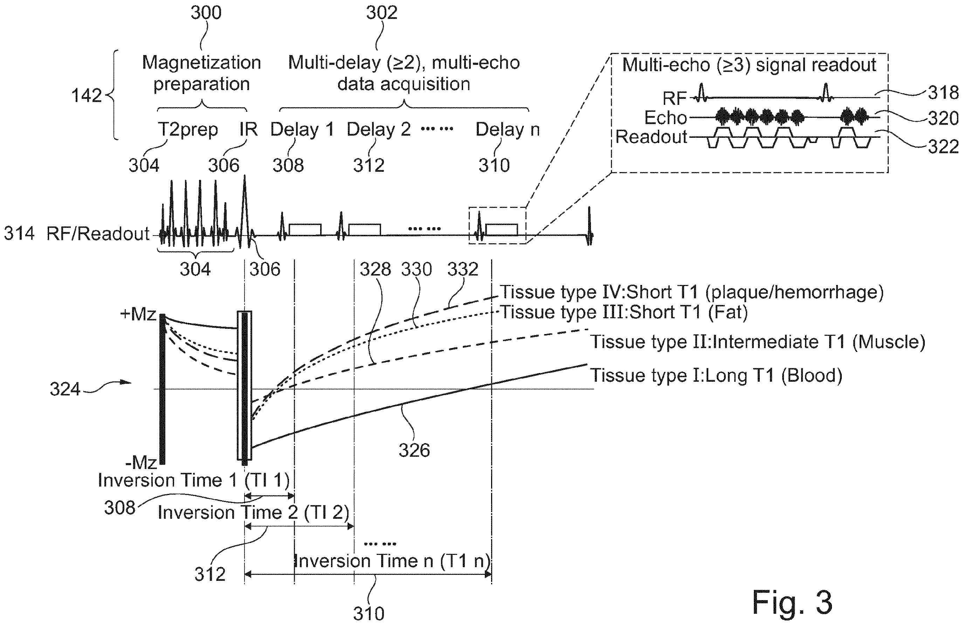

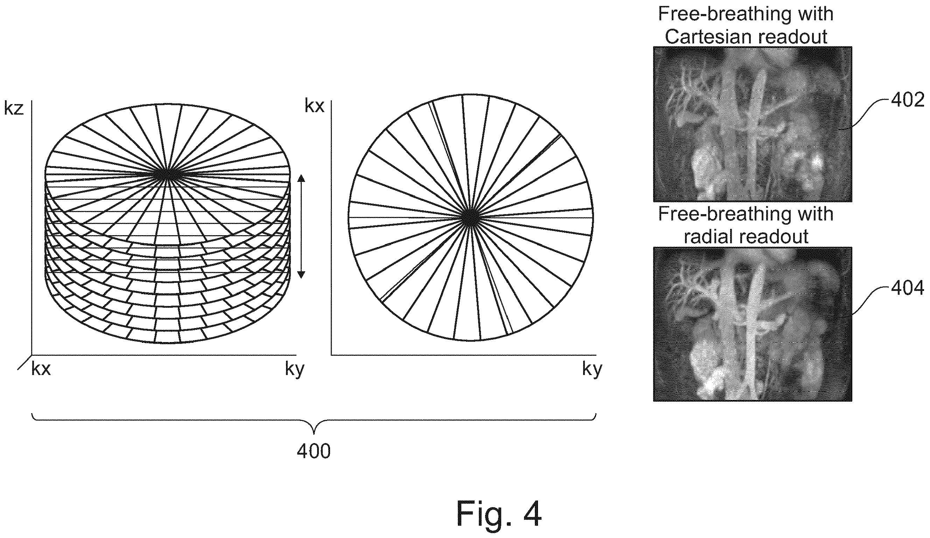

Examples may apply magnetization-prepared multi-delay, multi-echo acquisitions with chemical-shift based water-fat separation. It combines data acquisition after magnetization preparation with different delays (at least two) and signal readout with multiple echoes (at least three, typically six) (Fig. 3 below). Magnetization-preparation typically involves a T2prep pulse and a non-selective inversion recovery (IR) pulse. Multi-echo signal readout allows for not only chemical-shift type i.e. Dixon water-fat separation, but also capturing T2^{∗} signal delay. It can be performed by either conventional Cartesian or non-Cartesian such as radial or spiral stack-of-stars (Fig. 4 below) k-space trajectory. The later not only provides higher motion robustness (e.g. against respiratory) that allows free-breathing exams (e.g. under sedation), but also enables slide window reconstruction (e.g. with golden-angle type acquisition scheme) for arbitrarily defining the inversion times in a retrospective manner.

The time period during each preparation e.g., inversion interval is efficiently used by performing multi-delay acquisition, while the signal perturbation during echo generation is effectively captured by conducting multi-echo readout. An ad hoc selection of the inversion interval or time (TI) is not necessary, as for every delay or TI the obtained images give specific contrast depending primarily on tissue T1 relaxation time (e.g., tissue type I to IV in Fig. 3). Depending on the application and visualization goal, images with desired contrast can be chosen from one or more delays after data acquisition. Tissues (type IV) and fat (type III) with similarly short T1 can be distinguished by Dixon water-fat separation. The overall scan time is much shortened - one single scan at about 5 min - comparing to acquisition of multiple contrasts and/or parametric maps using separate sequences (typically 10 to 20 min).

Multiple datasets can be acquired following one (shared) magnetization preparation, for example, using T2prep and inversion pre-pulses, for multiple contrasts within one single scan for morphological evaluation. These include 1) T2^{∗} contrast from the multi-echo acquisition for assessment of the susceptibility effect due to e.g. iron deposit, which usually requires a separate scan in susceptibility weighted imaging (SWI) or quantitative susceptibility mapping (QSM), 2) T1 contrast from the multi-delay acquisition for optimal visualization of vasculatures (e.g. vessel lumen, heart chamber) and adjacent tissues (e.g. vessel wall) due to modulated signal (e.g. bright / gray / black blood) or lesions (e.g. thrombus, plaque, inflammation, myocardium scar) in case of contrast bolus uptake, which usually requires another separate scan in late-Gadolinium enhancement (LGE), in addition to 3) the native angiogram without contrast bolus (as described previously in REACT or REACT-MD).

In addition, multiple quantitative parametric maps can be derived at the end of the same single scan: Quantitative fat fraction (FF) map; Quantitative T2^{∗} / QSM map; Quantitative T1 map; Extra information: B0 map. These allow for quantitative characterization of the surrounding tissue and organs such as liver, muscles, nerves, and lesions such as tumors.

Moreover, as all datasets including multi-contrast images and quantitative maps are inherently spatially aligned from one single scan, no post-processing for misalignment is needed and a further detailed (voxel-based) analysis of the lesion composition and tissue classification is possible, e.g. by comparing the relative contributions of the lesion components with a dictionary, which may allow for an automated diagnosis.

Fig. 3 illustrates a timing diagram which is used to illustrate the pulse sequence commands 142 and the signal evolution 324. The pulse sequence commands 142 comprise a magnetization preparation portion 300 and then a multi-delay, multi-echo data acquisition portion 302. The magnetization preparation portion 300 comprises a T2 preparatory pulse 304 and an inversion recovery pulse 306. During the multi-echo data acquisition there are a first delay 308, a second delay 310 and then an arbitrary number of delays additionally 312. Below the graphical representation of the pulse sequence 142 is a timing diagram which illustrates both the contents of the RF and readout 314. The T2 preparatory pulses 304 are illustrated as well as the inversion recovery pulse 306. Each data acquisition during a shot 314 there is an additional readout timing diagram 316. The readout timing diagram 316 shows the readout of the RF pulses 318, the echo or measured k-space data 320 during an individual readout, and the readout gradient pulses 322. Below this is a transverse magnetization diagram 324 that corresponds in time to the illustrated pulse sequence commands and the timing diagram for RF and readout for a single shot 314.

Inversion time 1 corresponds to the first delay 308, the second inversion time corresponds to the nth delay and the nth inversion time corresponds to the additional delay 312. It can be seen that at the first inversion time the signal from the blood or tissue type 1 326, can be quite large, whereas the other tissue types, tissue type 2 328, tissue type 3 330, and tissue type 332 are all close to zero. At the first inversion time the signal from blood 326 would be large, any other tissue types will be small. This can be used for performing a black-blood image. At the inversion time 2 312 it can be seen that all of the tissue types have some magnetization. At the inversion time 310 for the nth delay, blood 326 is close to zero, whereas the other tissue types all have a significant signal.

The applicant notes that the delay 1, delay 2, ... delay n in Fig. 3 uses a labeling system distinct from the claims. In this particular example the first delay 308 is the same as delay 1, the second delay 210 corresponds to delay n, and the additional delay 312 corresponds to delay 2.

It can also be seen that at these various inversion times in this diagram it would not be advantageous to perform a conventional Dixon image because the water signal at the inversion time 312 would likely be too low.

Examples may contain one or more of the following steps/workflows:
- Apply magnetization preparation using T2prep and IR
- Apply multiple-delay acquisitions (at least two) with the 3D multi-echo Dixon method
- For multi-echo (at least three, typically six) readout, either Cartesian or non-Cartesian (e.g. spiral or radial stack-of-stars) k-space trajectory can be applied.
- Execute the scan to acquire an anatomical volume covering the anatomy of interest.
- By conducting multi-delay acquisitions, three image contrasts can be obtained from a single scan:
   o Bright-blood contrast for non-contrast-enhanced MRA (NCE-MRA)
   o T1-weighted contrast with different degrees for optimal tissue visualization, e.g. dark-blood, grey-blood
- By conducting multi-echo readout, at least one additional image contrasts can be obtained from the same scan:
   o T2^{∗}-weighted or susceptibility-weighted contrast
- Based on the acquired datasets with multiple contrasts, the following quantitative maps can be derived from the single scan:
   o Quantitative fat fraction (FF) map
   o Quantitative T2^{∗} map and susceptibility map (QSM)
   o Quantitative T1 map
   o Extra information: B0 map (Fig. 3)
- Apply MPR for arbitrary reformation, i.e. typically in all three orthogonal orientations.
- Apply overlay of the obtained two image datasets, for example, colour-encoded quantitative maps or dark-blood VWI over bright-blood NCE-MRA.
- Apply region-of-interest (ROI) analysis to measure the quantitative values.

Fig. 4 illustrates a k-space pattern for a single readout of the stack-of-stars 400. To the right of the sampling pattern 400 is an example of an image 402 that uses Cartesian k-space readout and also using an image 404 using radial k-space readout 404. It can be seen that the image that uses the radial k-space readout 404 has less blurring and is easier to interpret.

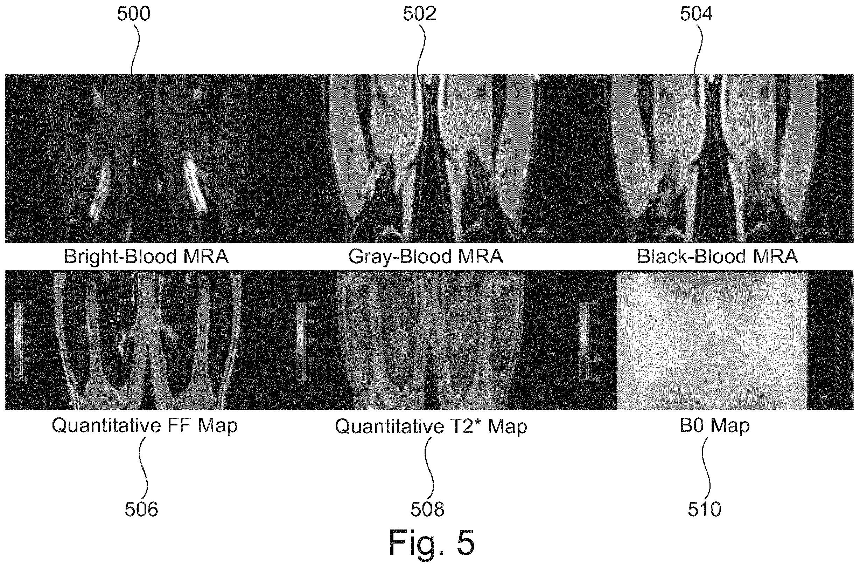

Fig. 5 illustrates the number of images that can be obtained using the medical system 100 and were acquired in the upper legs in the coronal orientation in a healthy subject (acquired spatial resolution: 1 x 1 x 1 mm3). There is a bright-blood image 500, a grey-blood image 502, and a black-blood image 504. Additionally, there is a quantitative fat fraction map 506 and a quantitative T2-star map 508. Additionally, there is a B0 map 510. The quantitative fat fraction map 506 and the B0 map 510 are examples of an additional magnetic resonance image 156 that would come from a conventional Dixon analysis.

MRI imaging of vasculatures and surrounding tissues for both morphological and functional evaluation. These include characterization of vascular abnormalities (e.g., stenosis, dissection), vessel wall lesions (thrombus, plaque, hemorrhage, lipid cap, inflammation, and scar pre- or post-Gd), and lesions in the muscles, nerves, and internal organs (e.g., liver) such as tumors.

Potential benefits of examples may include one or more of the following:
- Multiple image contrasts within one single scan
- Multiple parametric maps with quantitative relaxometry information from the same single scan
- All images are naturally co-registered
- Can be done with either Cartesian or non-Cartesian k-space trajectory
- Direct visualization of the multi-contrast images and multi-parametric quantitative maps
- Not rely on any biophysical modeling or dictionary matching
- No (intra-venous) contrast-bolus administration needed
- Can be done in free breathing
- Applicable to all field strengths

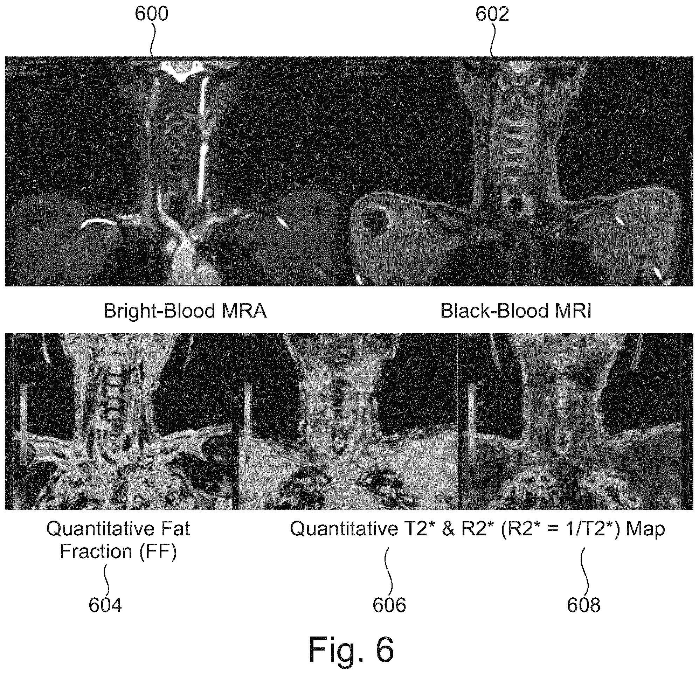

Fig. 6 illustrates further images that may be acquired in the medical system 100. Images were acquired in the subclavian and upper thoracic area in the coronal orientation in a healthy subject (acquired spatial resolution: 1.5 x 1.5 x 3.0 mm3). In this Fig. there is a bright-blood MRA 600 and a black-blood MRI 602 shown. Additionally, there is a quantitative fat fraction map 604. Likewise, there is a quantitative T2-star map 606 and R2-star map 608.

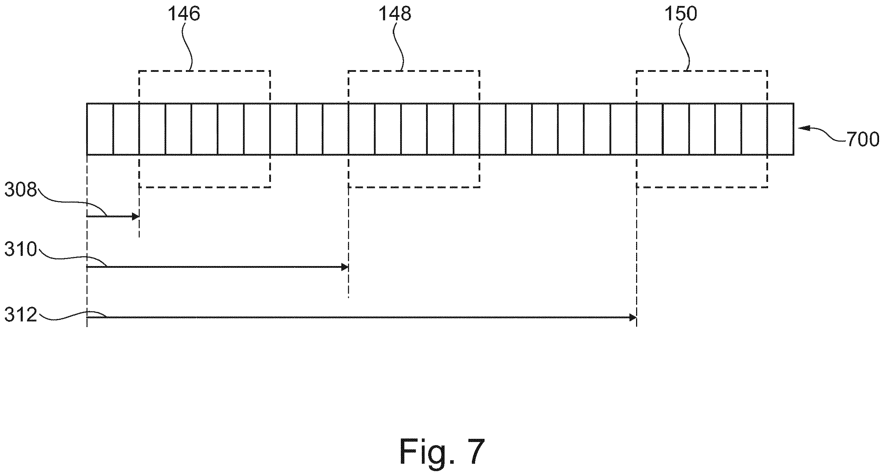

In Fig. 7 shown is continuously acquired k-space data 700. There is a first sliding window 702 that defines a first k-space data group 146. There is a second sliding window 148 that defines a second k-space data 148. There is a third or nth sliding window 704 that defines the additional k-space data group 150. By varying the first delay 308, the location of the first sliding window 701 can be modified thereby changing the first k-space data group's content. This also applies to varying the second delay 310 and third delay 312 to modify the position of the second sliding window 702 and the nth sliding window 704. When continuously acquired k-space data 700 is used these delays, 308, 310, 312, can be chosen or they may be determined iteratively by reconstructing images and then seeing the delays were chosen properly or if they need to be modified.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: magnetic resonance imaging system
- 104: magnet
- 106: bore of magnet
- 108: imaging zone
- 109: field of view
- 110: magnetic field gradient coils
- 112: magnetic field gradient coil power supply
- 114: radio-frequency coil
- 116: transceiver
- 118: subject
- 120: subject support
- 130: computer
- 132: computational system
- 134: hardware interface
- 136: user interface
- 138: memory
- 140: machine executable instructions
- 142: pulse sequence commands
- 144: k-space data
- 146: first k-space data group
- 148: second k-space data group
- 150: additional k-space data group
- 152: first Dixon water image
- 154: second Dixon water image
- 156: additional magnetic resonance image
- 158: composite image
- 160: quantitative magnetic resonance image
- 200: control the magnetic resonance imaging system with the pulse sequence commands to acquire the k-space data
- 202: form a first k-space data group by aggregating a first selected k-space data portion selected from the three or more k-space data portions from each of the multiple acquisition shots
- 204: form a second k-space data group by aggregating a second selected k-space data portion selected from the three or more k-space data portions
- 206: form at least one additional k-space data group by aggregating an additional selected k-space data portion each selected from the three or more k-space data portions
- 208: reconstruct a first Dixon water image from the first k-space data group to provide a bright blood non-contrast enhanced magnetic resonance imaging angiogram
- 210: reconstruct a second Dixon water image from the second k-space data group to provide a black-blood magnetic resonance vessel wall image
- 212: reconstruct an additional magnetic resonance image from each of the at least one additional k-space data group
- 214: reconstruct at least one quantitative magnetic resonance image from the k-space data
- 300: magnetization preparation portion
- 302: multi-delay, multi-echo k-space acquisition portion
- 304: T2 preparatory pulses
- 306: Inversion recovery pulse
- 308: First delay
- 310: additional delay
- 312: second delay
- 314: timing diagram for RF and Readout for single shot
- 316: readout timing diagram
- 318: RF pulses
- 320: measured k-space data
- 322: readout gradient pulses
- 324: transverse magnetization diagram
- 326: tissue type I
- 328: tissue type II
- 330: tissue type III
- 332: tissue type IV
- 400: k-space pattern for single readout of stack-of-stars
- 402: image using cartesian k-space data readout
- 404: image using radial k-space data readout
- 500: bright blood image
- 502: gray blood image
- 504: black-blood image
- 506: quantitative fat fraction map
- 508: quantitative T2-star map
- 510: B0 map
- 600: bright blood MRA
- 602: black blood MRI
- 602: quantitative fat fraction map
- 604: quantitative T2-star map
- 606: quantitative R2-star map
- 700: continuously acquired k-space data
- 702: first sliding window
- 704: second sliding window
- 706: additional sliding window

## Claims

1. A medical system (100) comprising:
- a magnetic resonance imaging system (102) configured for acquiring k-space data (144) from a subject (118);
- a memory (138) storing machine executable instructions (140) and pulse sequence commands (142), wherein the pulse sequence commands are configured to control the magnetic resonance imaging system to acquire the k-space data during multiple acquisition shots (314) according to a multi-echo gradient echo magnetic resonance imaging protocol, wherein for each of the multiple acquisition shots the pulse sequence commands are further configured to control the magnetic resonance imaging system to perform multiple k-space data readouts to acquire three or more k-space data portions, wherein the pulse sequence commands are further configured such that each of the three or more k-space data portions has a readout delay; and
- a computational system (132), wherein execution of the machine executable instructions causes the computational system to:
- control (200) the magnetic resonance imaging system with the pulse sequence commands to acquire the k-space data;
- form (202) a first k-space data group (146) by aggregating a first selected k-space data portion selected from the three or more k-space data portions from each of the multiple acquisition shots;
- form (204) a second k-space data group (148) by aggregating a second selected k-space data portion selected from the three or more k-space data portions, wherein the first k-space data group has a first readout delay (308), wherein the second k-space data group has a second readout delay (312), wherein the first second readout delay is greater than the second readout delay;
- form (206) at least one additional k-space data group (150) by aggregating an additional selected k-space data portion each selected from the three or more k-space data portions;
- reconstruct (208) a first Dixon water image (152) from the first k-space data group to provide a bright blood non-contrast enhanced magnetic resonance imaging angiogram;
- reconstruct (210) a second Dixon water image (154) from the second k-space data group to provide a black-blood magnetic resonance vessel wall image; and
- reconstruct (212) an additional magnetic resonance image (156) from each of the at least one additional k-space data group.

2. The medical system of claim 1, wherein at least one of the additional magnetic resonance image (156) reconstructed from the at least one additional k-space data group comprises at least one Dixon image, wherein the at least one Dixon image comprises any one of the following: a water image, a fat image, a fat fraction map, a B0 map, and combinations thereof.

3. The medical system of claim 2, wherein the at least one Dixon image comprises the B0 map, wherein execution of the machine executable instructions further causes the computational system to:
- reconstruct a magnitude image and a phase image from each of: the first k-space data group, the second k-space data group, and each of the at least one additional k-space data group;
I- calculate a quantitative susceptibility map from the B0 map and the magnitude image and a phase image from each of: the first k-space data group, the second k-space data group, and each of the at least one additional k-space data group.

4. The medical system of claim 1 or 2, wherein the execution of the machine executable instructions further causes the computational system to reconstruct (214) at least one quantitative magnetic resonance image from the k-space data.

5. The medical system of claim 4, wherein the at least one quantitative magnetic resonance image comprises a T2-star map, wherein execution of the machine executable instructions further causes the computational system to:
- reconstruct a magnitude image from the first k-space data group, the second k-space data group, and each of the at least one additional k-space data group; and
- calculate the T2-star map by performing a fitting to the magnitude image and readout delay of each of the three or more k-space data portions.

6. The medical system of claim 4 or 5, wherein execution of the machine executable instructions further causes the computational system to:
- form a k-space data grouping for each of the three of more k-space data portions by aggregating k-space data corresponding to a first echo of each of the three or more k-space data portions or corresponding to a Dixon water image of each of the three or more k-space data portions; and
- calculate a T1 map from the k-space data grouping for each of the three of more k-space data portions.

7. The medical system of any one of the preceding claims, wherein the second readout delay is configured such that longitudinal magnetization of blood has a magnitude below a predetermined blood magnetization threshold, and wherein the first readout delay is configured such that the longitudinal magnetization of blood is below a predetermined tissue magnetization threshold.

8. The medical system of any one of the preceding claims, wherein execution of the machine executable instructions further causes the computational system to form a composite magnetic resonance angiogram and vessel image by overlaying the first Dixon water image and the second Dixon water image, and wherein execution of the machine executable instructions further causes the computational system to overlay at least one additional magnetic resonance image on the composite magnetic resonance angiogram and vessel image.

9. The medical system of any one of the preceding claims, wherein the pulse sequence commands are configured to acquire the k-space data during multiple acquisition shots according using a rotating non-cartesian sampling pattern.

10. The medical system of claim 9, wherein the pulse sequence commands are configured to acquire the k-space data during the multiple acquisition shots continuously (700), wherein the wherein execution of the machine executable instructions causes the computational system to: form the first k-space data portion, the second k-space portion, and each of the at least one additional k-space data portion retrospectively.

11. The medical system of claim 9 or 10, wherein execution of the machine executable instructions further causes the processor to:
- adjust a location of a first sliding window (702) to group the k-space data into the first k-space data portion;
- adjust a location of a second sliding window (704) to group the k-space data into the second k-space data portion; and
- adjust a location of a additional sliding window (706) for each of the at least one additional k-space data portion to group the k-space data into each of the at least one additional k-space data portion.

12. The medical system of claim 11, wherein execution of the machine executable instruction further causes the computational system to: iteratively adjust the first sliding window location, the second sliding window location, and/or each additional sliding window to optimize an image quality of the first Dixon water image, the second Dixon water image, and/or each additional magnetic resonance image.

13. The medical system of any one of the preceding claims, wherein the pulse sequence commands are further configured to initially perform magnetization preparation pulses (300) for each of the multiple acquisition shots, wherein the magnetization preparation pulses are preferably configured to suppress magnetic resonance imaging signals from muscle tissue, nerve tissue, and/or internal organ tissue, and wherein the pulse sequence commands are further configured to perform an inversion recovery pulse with the magnetization preparation pulse.

14. A method of operating medical system (100) that comprises a magnetic resonance imaging system (102) configured for acquiring k-space data (144) from a subject (118), wherein the method comprises:
- controlling (200) the magnetic resonance imaging system with the pulse sequence commands (142) to acquire the k-space data, wherein the pulse sequence commands are configured to control the magnetic resonance imaging system to acquire the k-space data during multiple acquisition shots according to a multi-echo gradient echo magnetic resonance imaging protocol, wherein for each of the multiple acquisition shots the pulse sequence commands are further configured to control the magnetic resonance imaging system to perform multiple k-space data readouts to acquire three or more k-space data portions, wherein the pulse sequence commands are further configured such that each of the three or more k-space data portions has a readout delay;
- forming (202) a first k-space data group (146) by aggregating a first selected k-space data portion selected from the three or more k-space data portions from each of the multiple acquisition shots;
- forming (204) a second k-space data group (148) by aggregating a second selected k-space data portion selected from the three or more k-space data portions, wherein the first k-space data group has a first readout delay (308), wherein the second k-space data group has a second readout delay (312) , wherein the first second readout delay is greater than the second readout delay;
- forming (206) at least one additional k-space data group (150) by aggregating an additional selected k-space data portion each selected from the three or more k-space data portions;
- reconstructing (208) a first Dixon water image (152) from the first k-space data group to provide a bright blood non-contrast enhanced magnetic resonance imaging angiogram;
- reconstructing (210) a second Dixon water image (154) from the second k-space data group to provide a black-blood magnetic resonance vessel wall image; and
- reconstructing (212) an additional magnetic resonance image (156) from each of the at least one additional k-space data group.

15. A computer program comprising machine executable instructions (140) for execution by a computational system (132) controlling a medical system (100), wherein the medical system comprises a magnetic resonance imaging system (102) configured for acquiring k-space data (144) from a subject (118);
- a memory (138) storing machine executable instructions and pulse sequence commands, wherein execution of the machine executable instructions causes the computational system to:
- control (200) the magnetic resonance imaging system with pulse sequence commands (142) to acquire the k-space data, wherein the pulse sequence commands are configured to control the magnetic resonance imaging system to acquire the k-space data during multiple acquisition shots (314) according to a multi-echo gradient echo magnetic resonance imaging protocol, wherein for each of the multiple acquisition shots the pulse sequence commands are further configured to control the magnetic resonance imaging system to perform multiple k-space data readouts to acquire three or more k-space data portions, wherein the pulse sequence commands are configured such that each of the three or more k-space data portions has a readout delay;
- form (202) a first k-space data group (146) by aggregating a first selected k-space data portion selected from the three or more k-space data portions from each of the multiple acquisition shots;
- form (204) a second k-space data group (148) by aggregating a second selected k-space data portion selected from the three or more k-space data portions, wherein the first k-space data group has a first readout delay, wherein the second k-space data group has a second readout delay, wherein the first second readout delay is greater than the second readout delay;
- form (206) at least one additional k-space data group (150) by aggregating an additional selected k-space data portion each selected from the three or more k-space data portions;
- reconstruct (208) a first Dixon water image (152) from the first k-space data group to provide a bright blood non-contrast enhanced magnetic resonance imaging angiogram;
- reconstruct (210) a second Dixon water image (154) from the second k-space data group to provide a black-blood magnetic resonance vessel wall image; and
- reconstruct (212) an additional magnetic resonance image (156) from each of the at least one additional k-space data group.
